# EUROPEAN PATENT APPLICATION

(11) **EP 0 892 091 A1**
(43) Date of publication of application: **20.01.1999**
(21) Application number: 97304874.7
(22) Date of filing: 03.07.1997
(51) Int. Cl.: C30B 15/10, C30B 35/00, C30B 29/06

(54) **Graphite support vessels having a low concentration of calcium impurities and use thereof for production of single-crystal silicon**

(71) Applicant: MEMC Electronic Materials, Inc., St. Peters, Missouri 63376 (US)
(72) Inventor: Banan, Mohsen, St Louis, Missouri 63141 (US); Hansen, Richard Lee, Cleveland, Ohio 44117 (US)
(74) Representative: W.P. THOMPSON & CO.

(57) **Abstract**

Methods for producing single-crystal silicon (55) in a Czochralski-type crystal puller and novel graphite support vessels (e.g. susceptors (30)) used in such methods for supporting silica containers (e.g. crucibles (10; 10', 10'')) are disclosed. The concentration of alkaline-earth metal and alkali metal impurities, particularly calcium, present in a graphite support vessel (e.g. susceptor (30)) substantially affects non-uniform devitrification of a silica container (e.g. crucible (10; 10', 10'')) being supported by the support vessel (30) during production of single-crystal silicon (55) in a Czochralski-type crystal puller. Advantageously, the use of a graphite support vessel (30) having sufficiently low calcium concentration, preferably not in excess of about 1 ppm by weight, allows for the production of single-crystal silicon (55) without substantial non-uniform devitrification of the vitreous silica container (10; 10', 10'') holding the molten silicon (48) --- even where the silicon melt (48) is produced from a relatively higher capacity charge requiring heating of the support vessel (30) to relatively higher temperatures. Reducing the extent of localized crystallization of the vitreous silica container (10; 10', 10'') lowers the potential for a loss of structural integrity of the silica container (10; 10', 10'') and allows for improved silicon crystal quality, including improved zero-defect growth.

## Description

### BACKGROUND OF THE INVENTION

The present invention generally relates to the production of single crystal silicon, and specifically, to novel graphite susceptors used for supporting silica crucibles during growth of single crystal silicon ingots by the Czochralski method. The invention also relates to processes for preparing single crystal silicon using the novel susceptors.

Most single crystal silicon used for microelectronic circuit fabrication is prepared by the Czochralski (CZ) process. In this process, a single crystal silicon ingot is produced by melting polycrystalline silicon in a crucible, dipping a seed crystal into the molten silicon, withdrawing the seed crystal to initiate single crystal growth and growing the single-crystal ingot. Polycrystalline silicon is typically melted in vitreous silica (SiO₂) crucibles or other silica-lined containers. Vitreous silica is the amorphous form of silica, and crucibles made of vitreous silica are commonly referred to as quartz crucibles or fused quartz crucibles. Silica also exists in a variety of crystalline forms, including alpha and beta versions of quartz, tridymite and cristobalite.

Several problems exist, however, with the performance of silica containers at the high temperatures required to melt polycrystalline silicon. For example, vitreous silica becomes less viscous with increasing temperature and becomes soft enough to flow under an applied stress at temperatures exceeding about 1815 K. Hence, silica containers are susceptible to a loss of structural integrity, including sagging and/or other deformation during production of single-crystal silicon. As such, graphite support vessels such as susceptors or crucibles are typically used to support the silica crucibles, liners or other containers in which the polycrystalline silicon is melted. The graphite support vessels and/or the surfaces of the silica container in contact therewith can be coated, for example with SiC, TiC, NbC, TaC or ZrC (JP 7089789 A), or with glasseous carbon (U.S. Patent No. 5,476,679 to Lewis et al.). Moreover, the inner and/or outer surface of the silica container can include a uniform layer of crystalline silica (U.S. Patent No. 4,429,009 to Pastor et al.; U.S. Patent No. 5,053,359 to Loxley et al.) or be coated with a devitrification promoter to form such a uniform devitrified layer *in situ* (EP 0753605A).

Another problem associated with the high-temperature performance of silica containers is the localized transformation of vitreous silica to crystalline form (e.g. β-crystabolite), referred to as non-uniform devitrification. Crystabolite islands formed on the inner surface of the silica container can be released into the silicon melt and become incorporated into the growing crystal, thereby causing defects therein. Extensive non-uniform crystabolite growth can also cause a loss of structural integrity of the silica container, including flexing, bulging and other distortions and deformations in the shape of the silica container. Non-uniform devitrification of silica is reportedly influenced by the degree of purity of the silica and the level of contamination on the silica surface, with surface contamination promoting nucleation of the crystalline silica (e.g. crystabolite) and acting as a flux to transform the crystalline silica to other forms (e.g. from crystabolite to tridymite). Fused Quartz Products, General Electric Company General Catalog 7700, pp. 17-18, (January, 1987). Hence, approaches for minimizing the extent of non-uniform devitrification include improving the purity and surface cleanliness of the silica container. For example, Japanese Kokai No. 52/038873 discloses the use of a xenon lamp to irradiate the inner crucible surface in order to remove metallic contaminants electrostatically adhering to the silica surface. Japanese Kokai No. 60/137892 describes removal of alkali metals from a silica crucible using electrolysis.

Despite the aforementioned approaches, non-uniform devitrification and its adverse effects on the structural integrity of silica containers and on zero-defect crystal growth remain problematic. Because the rate of localized, non-uniform devitrification increases dramatically with increasing temperature, this problem is becoming particularly acute as the industry shifts to the production of larger-diameter single-crystal silicon ingots using larger polycrystalline silicon charges in larger capacity silica containers. The higher temperatures required in such applications increase the potential for substantial non-uniform devitrification, causing silica container deformation and, ultimately, decreased zero-defect growth of the single-crystal silicon ingot.

### SUMMARY OF THE INVENTION

It is therefore an object of the present invention to prepare single-crystal silicon of better quality, and particularly, to prepare single-crystal silicon from larger charges while reducing the extent of localized, non uniform devitrification of the silica container, thereby improving the structural integrity of the container and increasing the zero-defect growth of a silicon crystal grown therein. It is also an object of the invention to achieve single-crystal silicon of such improved quality in a cost effective manner with minimum impact on existing commercial production methods.

Briefly, therefore, the present invention is directed to a process for producing a single-crystal silicon ingot from polycrystalline silicon. According to the process, polycrystalline silicon is loaded into a silica container. The silica container can be a treated or untreated silica container. The container is supported by a graphite support vessel adapted to receive the silica container in a manner such that the container is nested in the graphite support vessel and the outer surface of the container contacts at least a portion of the inner surface of the support vessel. The region of contact between the inner surface of the support vessel and the outer surface of the container defines an interface region. The graphite support vessel is further adapted for use in a Czochralski-type crystal puller, and can be a treated or an untreated graphite support vessel such as a treated or an untreated graphite susceptor.

According to one embodiment of this process, the concentration of calcium present in the graphite support vessel is sufficiently low to prevent substantial non-uniform devitrification of the silica container at the interface region during subsequent process steps. In a preferred process, the concentration of calcium in the graphite support vessel is not in excess of about 1 ppm by weight. The concentration of calcium in the graphite support vessel is, in order of increasing preference, not in excess of about 0.7 ppm by weight, not in excess of about 0.2 ppm by weight, and not in excess of about 0.1 ppm by weight.

According to another embodiment of the process, the cumulative concentration of alkaline-earth metals and alkali metals present in the graphite support vessel is not in excess of about 1 ppm by weight. The cumulative concentration or metals selected from the group consisting of calcium, magnesium, strontium, lithium, sodium and potassium present in the graphite support vessel are preferably not in excess of about 0.7 ppm by weight. The concentration of calcium in the graphite support vessel of this process embodiment is preferably not in excess of about 0.2 ppm by weight.

In either of the aforementioned embodiments of the process, the support vessel, container and polycrystalline silicon are heated to melt the polycrystalline silicon and form a silicon melt. The graphite support vessel can be heated to obtain a temperature of at least about 1550 °C, preferably at least about 1575 °C, for a period of at least about 2 hours, preferably at least about 4 hours, at a region where the inner surface of a corner portion of the support vessel is in contact with the outer surface of a corner portion of the silica container. A single-crystal silicon ingot is drawn from the molten silicon.

The invention is also directed to a graphite support vessel, such as a susceptor or crucible, for use in nestably supporting a silica container during production of a single-crystal silicon ingot from a silicon melt formed within the container. The support vessel comprises a body consisting essentially of graphite.

Significantly, according to one graphite support vessel embodiment, the concentration of calcium present in the graphite body is not in excess of about 1 ppm by weight. The concentration of calcium present in the graphite body can be, in order of increasing preference, not in excess of about 0.7 ppm by weight, not in excess of about 0.2 ppm by weight and not in excess of about 0.1 ppm by weight.

According to another embodiment of the graphite support vessel, the cumulative concentration of alkaline-earth metals and alkali metals present in the graphite body is not in excess of about 1 ppm by weight. Preferably, the cumulative concentration of metals selected from the group consisting of calcium, magnesium, strontium, lithium, sodium and potassium present in the graphite body can be not in excess of about 0.7 ppm by weight. More preferably, the concentration of calcium in the graphite body can be not in excess of about 0.2 ppm by weight.

For either of the aforementioned embodiments of the graphite support vessel, the graphite body has an inner surface which defines an open cavity, the shape of such cavity being adapted to nestably receive a silica container with at least a portion of the inner surface of the body contacting an outer surface of the silica container to support the silica container during formation of a silicon melt in the silica container and during production of single crystal silicon from the melt. The body is designed to be suitable for use in a Czochralski-type crystal puller. The body can consist essentially of graphite or, alternatively, a coating can overly at least a portion of the inner surface of the body.

Other features and objects of the present invention will be in part apparent to those skilled in the art and in part pointed out hereinafter.

### BRIEF DESCRIPTION OF THE DRAWINGS

FIG. 1 is a section view of an empty Czochralski crucible.
FIG. 2 is a section view of an empty graphite susceptor suitable for use in supporting the crucible of Figure 1.
FIG. 3 is a schematic of a Czochralski-type crystal puller which includes a section view of the crucible of Figure 1 situated in and supported by the susceptor of Figure 2 for a configuration typically used in a batch process.
FIG. 4 is a schematic of a Czochralski-type crystal puller which includes a section view of an inner crucible and an outer crucible with the outer crucible situated in and supported by a susceptor for a configuration typically used in a continuous process.
FIG. 5 is a schematic block diagram showing a process for the production of graphite support vessels.
FIG. 6 is a plot illustrating whether zero-dislocation growth of single-crystal silicon was achieved during various runs with varying number of neck attempts using a silica crucible supported by a graphite susceptor having a calcium concentration ranging from 0.1 ppm to 0.2 ppm or ranging from 0.8 ppm to 1.7 ppm.

The invention is described in further detail below with reference to the figures, in which like items are numbered the same in the several figures.

### DETAILED DESCRIPTION OF THE INVENTION

According to the present invention, the concentration of alkaline earth metal and alkali metal impurities, particularly calcium, present in the bulk and on the surface of a graphite support vessel (e.g. susceptor) substantially affects the presence of and extent of non-uniform devitrification of a silica container (e.g. crucible) being supported by the support vessel during production of single-crystal silicon in a Czochralski-type crystal puller. Without being bound by theory, using a support vessel having a low concentration of alkaline-earth metal and alkali metal impurities reduces the extent of diffusion of the impurities from the support vessel to the outer surface of the silica container, thereby reducing the number of nucleation sites for localized crystallization and reducing the extent of non-uniform devitrification on the silica container. Single-crystal silicon can be produced using graphite support vessels having sufficiently low calcium concentration, preferably equal to or less than about 0.7 ppm by weight, even from high-capacity charges, without substantial non-uniform devitrification of the vitreous silica container. Reducing the extent of localized crystallization of the vitreous silica container improves the structural integrity of the silica container and allows for improved silicon crystal quality, including improved zero-defect growth.

As used herein, the term "container" is intended to include crucibles, liners or other vessels in which a pool of molten silicon can be formed for use in preparing a single-crystal silicon ingot in a Czochralski-type crystal puller. The term "support vessel" is intended to include susceptors, crucibles or other receptacles used to support a container. The term "polycrystalline silicon" is intended to include polycrystalline silicon without limitation as to shape, form or method of production, including for example "chunk" polycrystalline silicon typically prepared by a Siemens-type process and granular polycrystalline silicon typically prepared by a fluidized-bed reaction process.

Polycrystalline silicon is loaded into a silica container suitable for use in conjunction with the graphite support vessel of the present invention to prepare single crystal silicon by the Czochralski method. The silica container can be an untreated vitreous silica container consisting essentially of silica, or alternatively, a treated silica container comprising a vitreous silica vessel having inner and outer surfaces where at least a portion of the inner and/or the outer surface of the silica vessel has been treated according to various methods presently known or later developed in the art. Such treatment methods presently include, for example, forming external coatings (e.g. SiN) on the surface or growing such coatings *in situ* at the surface. It is generally preferred to form a uniform layer of devitrified silica at the surface or to uniformly apply a devitrification promoter to encourage the formation of such a uniform devitrified layer. The formation and use of a uniform devitrified layer on a surface of the silica container is distinguished from the non-uniform devitrification sought to be prevented by the present invention in terms of the degree of control over the devitrifying process and in terms of the uniform and non-localized nature of the resulting devitrified silica layer. Regardless of whether the container is treated or untreated, the bulk of the silica container is preferably substantially free of alkaline-earth metal, alkali metal and other impurities, and the surface of the silica container is preferably substantially free of non-uniformly-distributed alkaline-earth metal and alkali-metal impurities on its inner or outer surfaces. Silica containers of suitable quality are commercially available from a variety of sources, including for example, General Electric Co., Quartz Products Department (Cleveland, Ohio).

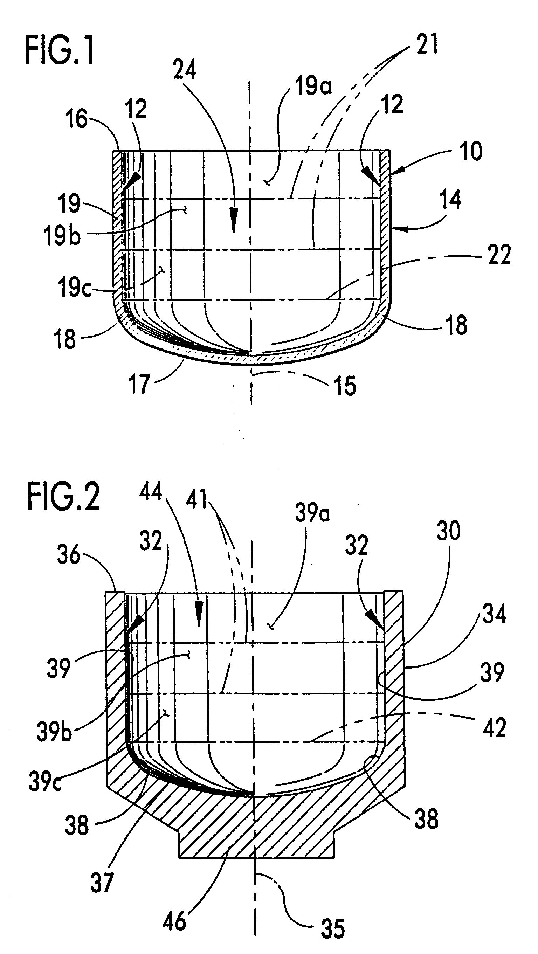

While the particular geometry of the silica container is not narrowly critical, the container will generally be cup-shaped and have inner and outer surfaces which define an at least partially closed structure capable of containing or otherwise holding a liquid such as molten silicon. Referring to Figure 1, an exemplary silica container is an untreated silica crucible 10. The crucible 10 generally has an inner surface 12, an outer surface 14, a centerline 15 and a top edge 16. The inner surface 12 defines an open cavity 24 into which polycrystalline silicon is loaded. The crucible 10 includes a bottom portion 17, a corner portion 18 and a side or wall portion 19, referred to hereinafter as the bottom 17, corner 18 and wall 19, respectively of the crucible 10. In the illustrated embodiment, the wall 19 is substantially vertical and the bottom 17 is substantially horizontal. More precisely, the wall 19 defines a substantially vertical circumferential area which includes a top portion 19a, a middle portion 19b and a bottom portion 19c, the top, middle and bottom portions 19a, 19b, 19c each including about 1/3 of the total surface area of the wall 19. The approximate divisions between the top, middle and bottom portions 19a, 19b and 19c are generally illustrated by phantom lines 21. The bottom 17 is parabolic, having a slope with a substantially greater horizontal component than vertical component. The corner 18 is a curved annular boundary region in the vicinity of the intersection of the wall 19 and bottom 17. The corner 18 intersects the wall 19 where the curvature of the corner 18 ceases, illustrated generally as line 22. The corner 18 has a radius of curvature which is less than the radius of curvature of the bottom 17 and generally intersects the bottom 17 where the radius of curvature changes. The corner 18 has upper and lower halves each of which include about half of the total surface area of the corner 18, with the upper half being closer to the wall 19 and the lower half being closer to the bottom 17. The centerline 15 of the crucible 10 is substantially parallel to the wall 19 and intersects a geometric centerpoint of the bottom 17.

A graphite support vessel supports the silica container during formation of silicon melt therein and during production of single-crystal silicon from the molten silicon. The graphite support vessel can be an untreated or treated graphite support vessel. An untreated graphite support vessel consists essentially of carbon in its graphite form. A treated graphite support vessel comprises a core vessel which consists essentially of graphite and has inner and outer surfaces where at least a portion of the inner and/or the outer surface of the core vessel has been treated (e.g. coated) according to various methods presently known or later developed in the art. Such treatment methods presently include, for example, forming coatings of SiC, TiC, NbC, TaC, ZrC, BN or glasseous carbon on the surface or growing such coatings *in situ* at the surface of the core vessel.

While the particular geometry of the graphite support vessel is not narrowly critical, the support vessel will generally be cup-shaped and have inner and outer surfaces that define a structure which is adapted to receive a silica container such that the silica container is nested in the graphite support vessel with at least a portion of the inner surface of the support vessel being in contact with at least a portion of the outer surface of the container. The region of contact between the inner surface of the support vessel and the outer surface of the container defines an interface region. The support vessel is preferably further adapted for use in a Czochralski-type crystal puller. Referring to Figure 2, an exemplary graphite support vessel is an untreated graphite susceptor 30. The susceptor 30 has an inner surface 32, an outer surface 34, a centerline 35 and a top edge 36. The inner surface 32 of the susceptor 30 defines an open cavity 44 and includes a bottom portion 37, a corner portion 38 and a side or wall portion 39, referred to hereinafter as the bottom 37, corner 38 and wall 39, respectively, of the susceptor 30. In the illustrated embodiment, the susceptor bottom 37 is substantially horizontal and the susceptor wall 39 is substantially vertical. More specifically, the bottom 37 is approximately parabolic and has a slope with a substantially greater horizontal component than vertical component. The susceptor wall 39 defines a circumferential area, which includes a top portion 39a, a middle portion 39b and a bottom portion 39c, the top, middle and bottom portions 39a, 39b and 39c each including about 1/3 of the total surface area of the wall 39. The approximate divisions between the top, middle and bottom portions 39a, 39b and 39c are generally illustrated by phantom lines 41. The susceptor wall 39 is tapered open slightly relative to the true vertical, such that the diameter of the wall 39 at the top edge 36 of the susceptor 30 is slightly greater than the diameter of the wall 39 measured at point lower in the wall 39, for example, at the bottom portion 39b of the wall 39. The slightly open-tapered wall 39 facilitates receipt of a silica crucible 10 or other silica container into the open cavity 44. The susceptor corner 38 is a curved annular boundary region in the vicinity of the intersection of the wall 39 and bottom 37. The corner 38 intersects the wall 39 where the curvature of the corner 38 ceases, illustrated generally as line 42. The corner 38 has a radius of curvature which is less than the radius of curvature of the bottom 37 and generally intersects the bottom 37 where the radius of curvature changes. The corner 38 has upper and lower halves each of which include about half of the total surface area of the corner 38, with the upper half being closer to the wall 39 and the lower half being closer to the bottom 37. The centerline 35 of the susceptor 30 is substantially parallel to the wall 39 and intersects a geometric centerpoint of the bottom 37. The susceptor 30 further includes a base 46 located underneath the bottom portion 37 of the inner surface 32. The base 46 is adapted for connection to a movable pedestal 52 of a Czochralski-type crystal puller.

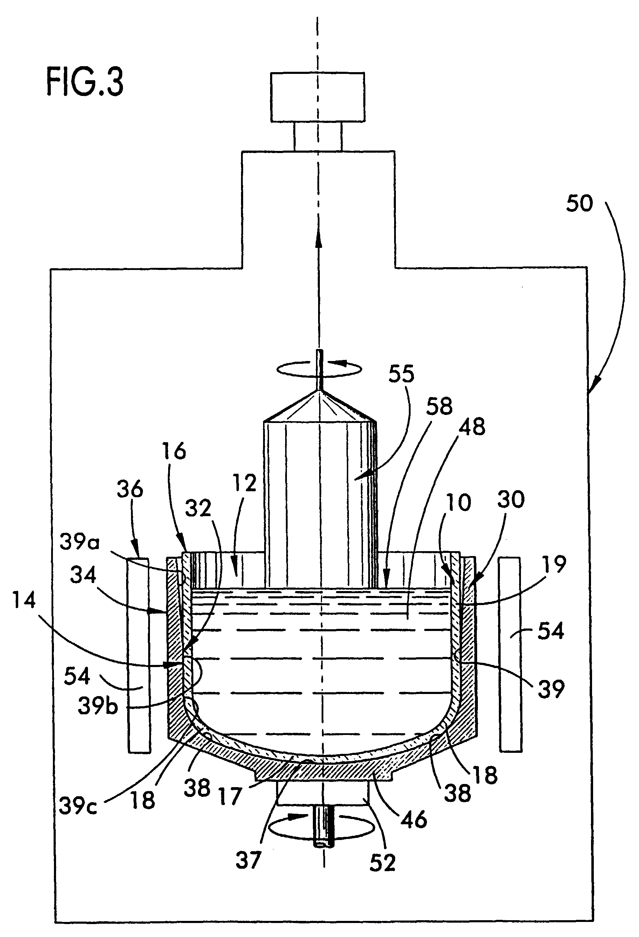

Figure 3 shows crucible 10 situated in and supported by susceptor 30 in a Czochralksi-type crystal puller 50, with the base 46 of the susceptor 30 attached to a movable pedestal 52. This configuration is typical for producing single-crystal silicon using a batch Czochralski-type process. The portion of the inner surface 32 of the susceptor 30 defined by the bottom 37, corner 38 and bottom portion 39b of the wall 39 is in contact with the outer surface 14 of the corresponding portions 17, 18 and 19b of the crucible 10. The interface region for this container-support vessel system is defined by this area of contact between the crucible and the susceptor. In the general case, however, the extent and specific location of the interface region will depend on the particular designs for the silica container and the graphite support vessel. Such designs are generally based on structural support and heat transfer considerations. Moreover, the area of contact defining the interface region will, for batch processes, vary with time during the crystal-growing process. With reference to Figure 3, after a silicon melt is formed in the silica crucible 10, the molten silicon 48 which is below the melt surface 58 exerts a hydrostatic (gravitational) force on the wall 19, corner 18 and bottom 17 of the crucible 10. Because the heated silica container is softened at the melt temperatures, the hydrostatic / gravitational forces operate to force the softened silica container against the graphite support vessel. In a batch process, however, the level of the molten silicon decreases as the silicon ingot forms, and therefore, the hydrostatic pressure exerted on the wall 19, corner 18 and bottom 17 decreases as the single crystal ingot is drawn, thereby allowing the upper portions 19a, 39a of the walls 19 39 to release from each other, and resulting in a decrease in the amount of contact between the outer surface 14 of crucible wall 19 and the inner surface 32 of the support vessel wall 39 as the crystal is pulled. In general, therefore, it is possible to define subregions of the interface region based upon the time of contact between the walls of the silica container and the support vessel: (1) a no-contact region which is located substantially above the initial melt line (ie, above the initial level of the surface 58 of the molten silicon 48); (2) a temporary-contact region which is located substantially below the initial melt line but substantially above the final melt line; and (3) a continuous-contact region located substantially where the hydrostatic pressure and/or the weight of the silica container forces the softened container against the support vessel during the entire crystal-pulling process. For the container/support-vessel system illustrated in Figures 1 through 4, the no-contact region correlates roughly with the top one-third of the interface region between the walls of the silica container and the graphite susceptor, illustrated therein as the top portions 19a and 39a, of the container and support vessel walls, respectively. The temporary-contact region generally correlates with the bottom two-thirds of the walls and the upper-half of the corner element. In Figures 1 through 4, for example, the temporary contact region may include the wall portions 19b, 19c, 39b, 39c and the upper halves of the corners 18, 38. The continuous contact region generally correlates with the bottoms 17, 37 and the lower halves of the corners 18, 38.

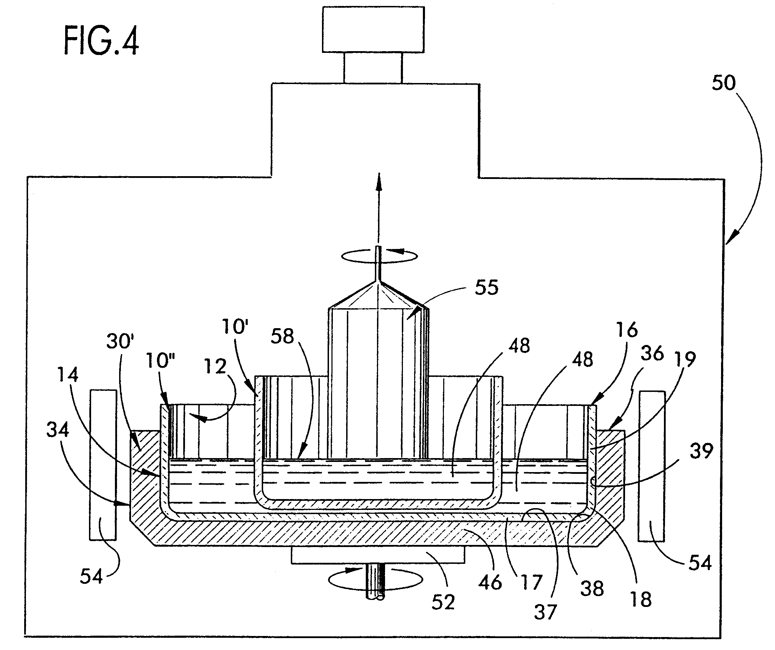

The geometries of the crucible 10 and susceptor 30 illustrated in Figures 1, 2 and 3, respectfully, are exemplary. The geometries of the silica container and the graphite support vessel may vary substantially from the illustrated embodiments and still fall within the scope of the invention. One alternative design for the silica container and the graphite support vessel is shown in Figure 4. In this design, a double container system comprising an inner crucible 10' and an outer crucible 10'' situated in and supported by a graphite support vessel (susceptor 30') are configured in a manner which is typical for preparation of single-crystal silicon using a continuous Czochralski-type process.

Regardless of whether the graphite support vessel is treated or untreated, and regardless of the particular geometry of the support vessel, the cumulative concentration of alkali metals and/or alkaline-earth metals, particularly calcium, magnesium, strontium, lithium, sodium and potassium, which are present as impurities in bulk of the graphite support vessel and on its surface should generally be sufficiently low to prevent substantial non-uniform devitrification of the silica container at the interface region while the polycrystalline silicon is melted and the single-crystal silicon ingot is drawn from the molten silicon. As used herein, the term "substantial non-uniform devitrification" is intended to mean localized crystallization of the vitreous silica which results in a commercially significant decrease in the structural integrity of the silica container (e.g. cusping, fluxing, pitting, bulging, bowing and/or other deformation) and/or a commercially significant decrease in the zero-dislocation length upon growth of a single-crystal silicon ingot from a silicon melt formed in the silica container. The decrease in zero-dislocation length is preferably less than about 10%, more preferably less than about 5%, even more preferably less than about 1% and most preferably less than about 0.5%. While a decrease in zero-dislocation length of more than about 0.5% is presently considered commercially significant, a smaller decrease may be significant in the future. Substantial non-uniform devitrification is typically characterized by several observable features such as excessive formation of white powder, accompanied by significant pitting, cusping and/or fluxing. Fluxing relates to a localized softening of the silica container and is evidenced by a visually shiny or glossy appearance on the outer surface of the silica container. Fluxing is a particularly relevant indicator of detrimental non-uniform devitrification. As such, the cumulative concentration of alkali metals and/or alkaline-earth metals present in the graphite support vessel, particularly calcium, magnesium, strontium, lithium, sodium and potassium, is preferably low enough to avoid fluxing an area of greater than about 1 cm². More preferably, the cumulative concentration is low enough such that less than about 0.5 cm² is fluxed.

In general, the concentration of the aforementioned impurities, particularly calcium, in an untreated graphite support vessel being used with an untreated silica container, is preferably equal to or less than about 1.0 ppm relative to the weight of the graphite material of which graphite support vessel is composed. (*See*, for example, Example 1). The concentration of the aforementioned impurities present in such a graphite support vessel is, in order of increasing preference, less than about 0.7 ppm by weight, less than about 0.5 ppm by weight, less than about 0.2 ppm by weight and most preferably less than about 0.1 ppm by weight. When either the inner surface of the support vessel or the outer surface of the silica container are treated, as described above, such that at least one surface at the interface region is a treated surface, a higher concentration of alkali metal and alkaline-earth metal impurities, particularly Ca, can be tolerated without substantial non-uniform devitrification. The exact upper concentration limit of alkali and/or alkaline-earth metal impurities for avoiding substantial, non-uniform devitrification may vary depending on factors which include the cleanliness of the surfaces of the silica container and/or the graphite support vessel, the hot-zone temperature profile (temperature and time) being used for a particular crucible size and charge size, whether the silica container and/or graphite support vessel are treated, etc. Nonetheless, single crystal silicon of improved quality can be obtained according to the guidance and preferred concentration limits set forth above.

Once the polycrystalline silicon is loaded into a suitable silica-container/graphite-support-system, the crucible can be placed in a conventional CZ silicon crystal growth apparatus and the polycrystalline silicon can be heated to melt the polycrystalline silicon until a pool of molten silica forms in the silica container. The heating profile is not narrowly critical, and will generally vary depending on the type of loading (ie, chunk, granular or mixed loadings), the size and design of the crucible, the size and type of crystal grower, etc. In a typical arrangement, referring to the crucible / susceptor system illustrated in Figures 3 and 4, the pedestal 52 supporting the base 46 of the susceptor 30 is positioned such that the bottom 17 of the crucible 10 is near the top of the heater 54. The crucible 10 is gradually lowered into the space inside the heater 54. The speed at which the crucible 10 is lowered into closer proximity of the heater 54 and the value of other factors affecting melting of the polycrystalline silicon, such as heater power, crucible rotation and system pressure, are generally known in the art.

Ordinarily, the temperature of the region of contact between the crucible 10 and susceptor 30 at corners 18, 38 is at least about 1500 °C for an 18" (about 46 cm) diameter crucible charged with about 60 kg polycrystalline silicon during a meltdown period ranging of about 4 hours and, alternatively, at least about 1550 °C for an 18" (about 46 cm) diameter crucible charged with about 70 kg polycrystalline silicon during a meltdown period ranging from about 4 hours to about 6 hours. Higher temperatures -- preferably at least about 1575 °C, at least about 1600 °C or at least about 1625 °C -- can also be used in such 18"/60 kg or 18"/70 kg systems to effect a shorter meltdown period without detrimental effect on the structural integrity of the silica container or graphite support vessel. The advantage of the present invention is particularly significant using larger diameter silica containers and/or larger charge sizes. For example, the temperature of the high heat-flux corner region is preferably at least about 1600 °C for a 22" (about 56 cm) diameter crucible charged with about 100 kg of polycrystalline silicon during a melt-down period ranging from about 7 hours to about 10 hours, or with a larger, 120 kg, charge and a melt-down period of about 10 hours. However, even higher temperatures can be used -- at least about 1675 °C or at least about 1700 °C -- with such a 22"/120 kg system to effect a commensurately shorter meltdown period (e.g. ranging from about 6 hours to about 8 hours). For a larger silica container, such as a 24" (about 61 cm) diameter crucible charged with about 140 kg of polycrystalline silicon, the corner temperature is preferably at least about 1650 °C, and can also be at least about 1675 °C or at least about 1700 °C. The meltdown period for such a 24"/140 kg system will vary with temperature, but can typically range from about 10 hours to about 12 hours at about 1650 °C and from about 8 hours to about 10 hours at temperatures ranging from about 1675 °C to about 1700 °C. As another example, a 32" (about 81 cm) diameter crucible charged with an amount of polycrystalline silicon ranging from about 160 kg to about 200 kg can be heated to a corner temperature of at least about 1650 °C, or more preferably, at least about 1675 °C or at least about 1700 °C. These higher temperatures are preferred to allow for a melt-down period for such a 32"/160-200 kg system which is commercially reasonable -- for example, ranging from about 12 hours to about 15 hours. The aforementioned silica container diameters, charge sizes and melt-down periods, and particularly, the combination of such parameters with the various temperatures, are recited as being exemplary of the advantages of the present invention, and are not intended to be limiting as to the scope of the invention. A person skilled in the art will readily appreciate that the use of the aforedescribed low impurity support vessel allows, in general, for the silica container to be heated to higher temperatures without the detrimental effects on crystal growth which are associated with known systems. The capability of using higher temperatures translates into increased productivity through either larger charge sizes and/or reduced melt-down periods.

The polycrystalline silicon is typically exposed, while heating, to a purge gas to flush out undesirable gasses such as SiO(g) and CO(g) originating from the reaction of SiO(g) with hot graphite. The purge gas is typically an inert gas such as argon and typically flows at a rate ranging from about 10 l/min to about 300 l/min, depending on the type and size of the crystal puller.

Once the silicon melt is formed, a single-crystal silicon ingot is drawn from the molten silicon according to a Czochralski-type process. With reference to Figures 3 and 4, the single-crystal silicon ingot 55 is drawn in a Czochralski-type crystal puller 50 from a silicon melt formed in a silica crucible 10 supported by a graphite susceptor 30. The particular methods and conditions for drawing the single-crystal silicon ingot are known in the art. The high temperatures established during melt formation are generally maintained while the single-crystal silicon melt is drawn. Advantageously, when the high purity graphite support vessels (e.g. susceptor 30) of the present invention are used to support a silica container (e.g. crucible 10), the temperature of the portion of the graphite support vessel subjected to the highest heat flux and having the highest temperatures (e.g., typically, the corner region of the support vessel) can be maintained at or above about 1500 °C, or if necessary, at or above about 1525 °C, 1550 °C, 1575 °C, 1600 °C, 1625 °C, 1650 °C, 1675 °C or 1700 °C during production of the single-crystal silicon ingot therefrom (typically, for a period of at least about 4 hours or at least about 5 hours) without causing substantial non-uniform devitrification of the silica container in the interface region. While the temperature of the graphite support vessel (e.g. susceptor 30) will vary during the course of forming a silicon melt and drawing the crystal, and may, for certain periods of time, also vary locally between different portions of the support vessel, the time-averaged temperature at a particular location of the susceptor will generally be higher for larger diameter crucibles having larger capacity charges of polycrystalline silicon. In general, the upper concentration limit on alkali and alkaline-earth metal impurities in the graphite support vessel will decrease as any or all of the following parameters increase: crucible size (e.g. diameter), charge size (e.g. weight), support vessel temperature at its corner radius, and time at a temperature above about 1500 °C. The aforementioned concentration and temperature values are to be considered exemplary and instructive only; in general, the most preferred concentration of alkali and alkaline-earth metals for any system or configuration is, as discussed above, a concentration sufficiently low to prevent substantial non-uniform devitrification of the silica container at the interface region while the polycrystalline silicon is melted and the single-crystal silicon ingot is drawn from the molten silicon.

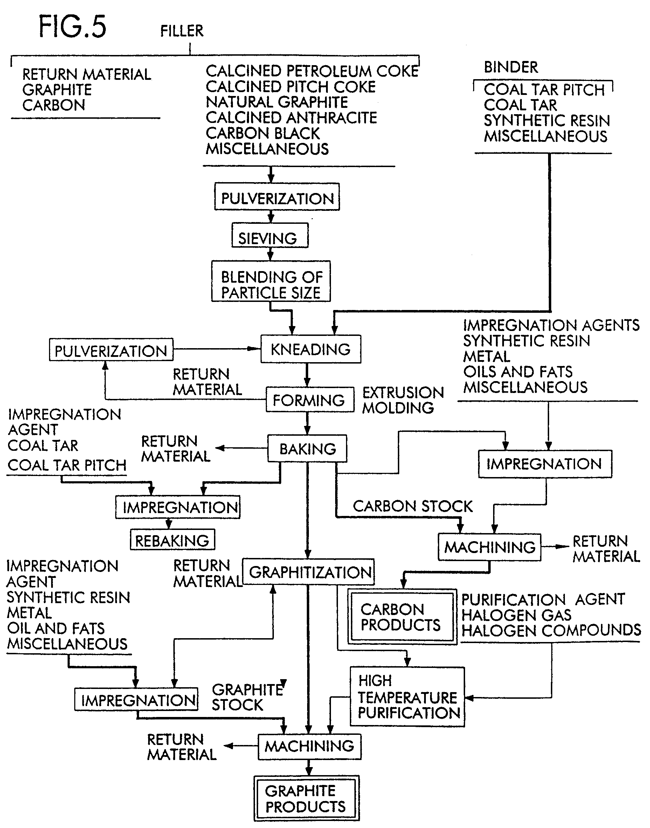

High purity graphite support vessels having alkaline-earth metal and alkali metal impurities, particularly calcium impurities, present at concentrations suitable for use in the present invention can be prepared in the same general manner in which such support vessels are currently made, with particular attention made to selection of filler and binder raw materials having a lower concentration of such impurities, and with special emphasis on purification steps, to ensure a satisfactorily low level of alkali and alkaline-earth metal impurities. A detailed description of the manufacturing process for producing graphite is set forth in T. Ishikawa & T. Nagaoki (English Editor I.C. Lewis) Recent Carbon Technology, especially pp. 22-58, JEC Press, 1983. Briefly, referring to Figure 5, a filler material (e.g. calcinated petroleum coke) is pulverized, sieved and blended to a relatively uniform particle size and then combined with a binder (e.g. coal tar pitch) in a kneading process. After mixing the filler and binder materials, the resulting mixture is formed into the desired shape (e.g. ingot), typically by a molding or extrusion process. The formed material is then baked in a carbonization process, and the resulting carbonized material is graphitized, either directly, or following steps during which it is impregnated and rebaked to increase its density and/or following high-temperature purification steps. Ordinarily, such purification steps include subjecting either baked carbon and/or graphitized carbon to halogen gasses at temperatures of about 2500 °C for extensive periods of time. Alkali and alkaline-earth metal impurities are removed during the graphitization steps, and/or through refining treatments in which impurities are removed using high-temperature purification processes. The stock graphite is then machined to form the graphite support vessel of the present invention. Commercial manufacturers of graphite support vessels (e.g. UCAR, Clarksburg, WVa) are capable of achieving the purity levels required for the graphite support vessels of the present invention.

The following example illustrates the principles and advantages of the invention.

### EXAMPLE

### Example 1: Production of Single-Crystal Silicon Using Graphite Susceptors Having Various Concentrations of Calcium

In several experimental runs, single-crystal silicon ingots were produced from silicon melts formed in untreated vitreous silica crucibles. The silica crucibles were supported by graphite susceptors having varying concentrations of calcium (ranging from about 0.1 ppm to about 1.8 ppm). The number of neck attempts to draw the silicon ingot was recorded.

Following single-crystal silicon production, the quality of the vitreous quartz crucible used in each run was observed, with particular attention to the level of devitrification, pitting, cusping and fluxing of the crucible wall. The crucibles used with the susceptors having a high concentration of calcium (ranging from 0.8 ppm to about 1.7 ppm) were observed to have heavy devitrification, with a significant amount of pitting, cusping and fluxing of the crucible wall. In contrast, the silica crucibles used with the graphite susceptors having a low concentration of calcium (ranging from about 0.1 ppm to about 0.2 ppm) were observed to have, at most, light devitrification, with a minimum amount of cusping, fluxing and pitting of the crucible wall.

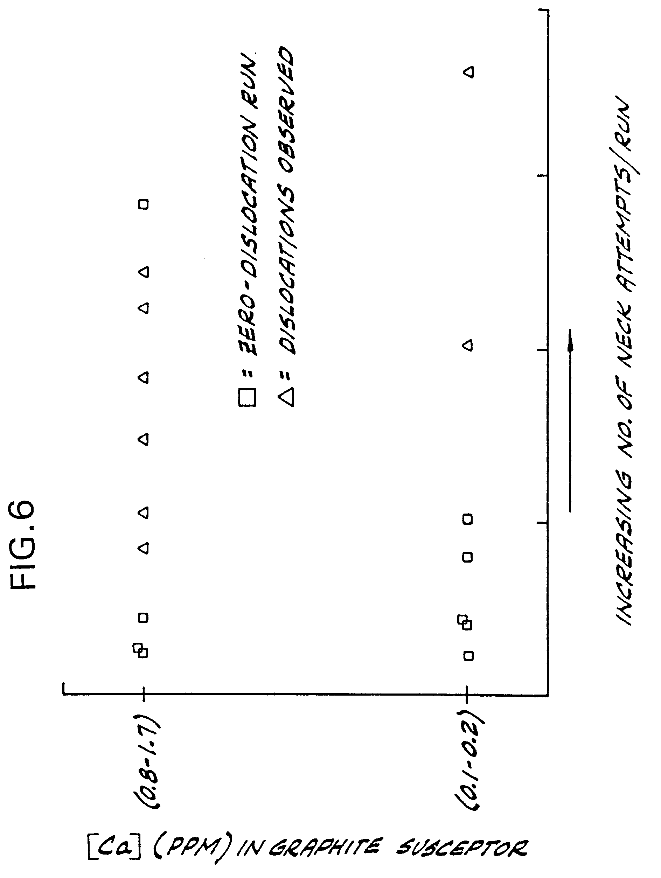

The presence or absence of dislocations in the resulting single-crystal ingots was also determined. The results are summarized in Figure 6, which shows whether zero-dislocation growth of single-crystal silicon was achieved using varying number of neck attempts and using a graphite susceptor having various concentrations of calcium --- grouped in Figure 6 as having either a high calcium content (ranging from 0.8 ppm to about 1.7 ppm) or a low calcium content (ranging from about 0.1 ppm to about 0.2 ppm). The data of Figure 6 indicates that for runs in which the silicon crystal was drawn with a low number of neck attempts, zero-dislocation growth was achieved in 100% of cases using the low-calcium-content susceptors, but in only 60% of the cases using the high-calcium-content susceptors. When all of the data is considered, without regard to the number of neck attempts required to initiate crystal growth, zero-dislocation growth was achieved in 72% of the cases using the low-calcium-content susceptors, but in only 40% of the cases using the high-calcium-content susceptors. As such, the use of low-calcium-content susceptors clearly impacts the extent to which zero-dislocation growth of single-crystal silicon is achieved.

In light of the detailed description of the invention and the examples presented above, it can be appreciated that the several objects of the invention are achieved. The explanations and illustrations presented herein are intended to acquaint others skilled in the art with the invention, its principles, and its practical application Those skilled in the art may adapt and apply the invention in its numerous forms, as may be best suited to the requirements of a particular use. Accordingly, the specific embodiments of the present invention as set forth are not intended as being exhaustive or limiting of the invention.

## Claims

1. A process for producing a single-crystal silicon ingot from polycrystalline silicon according to a Czochralski-type approach, the process comprising
forming a pool of molten silicon (48) in a silica container (10; 10', 10'') having an outer surface (14),
supporting the silica container (10; 10', 10'') with a graphite support vessel (30) having an inner surface (32), at least a portion of the inner surface (32) of the support vessel (30) contacting the outer surface (14) of the silica container (10; 10', 10''), and
drawing a single-crystal silicon ingot (55) from the molten silicon (48),
characterized in that the concentration of calcium in the graphite support vessel (30) is not in excess of about 1 ppm by weight.

2. A process according to claim 1, characterized in that the concentration of calcium in the graphite support vessel (30) is not in excess of about 0.7 ppm by weight.

3. A process according to claim 1 or claim 2, characterized in that the concentration of calcium in the graphite support vessel (30) is not in excess of about 0.2 ppm by weight.

4. A process according to any one of claims 1 to 3, characterized in that the concentration of calcium in the graphite support vessel (30) is not in excess of about 0.1 ppm by weight.

5. A process according to any one of claims 1 to 4, characterized in that the graphite support vessel (30) is heated to obtain a temperature of at least about 1575°C for a period of at least about 4 hours at a region where the inner surface of a corner portion (38) of the support vessel (30) is in contact with the outer surface of a corner portion (18) of the silica container (10; 10', 10'').

6. A process according to any one of claims 1 to 5, characterized in that the graphite support vessel (30) is an untreated graphite support vessel.

7. A process according to any one of claims 1 to 5, characterized in that the silica container (10; 10', 10'') is a treated silica container.

8. A process according to any one of claims 1 to 7, characterized in that the cumulative concentration of alkaline-earth metals and alkali metals present in the graphite support vessel (30) is not in excess of about 1 ppm by weight.

9. A graphite support vessel (30) for supporting a silica container (10; 10', 10'') during production of single-crystal silicon (55) from a silicon melt (48) formed within the silica container (10; 10', 10'') according to a Czochralski-type approach, the support vessel (30) comprising
a body consisting essentially of graphite and having an inner surface (32) which defines an open cavity (44) capable of nestably receiving a silica container (10; 10', 10'') with at least a portion of the inner surface (32) of the body contacting an outer surface (14) of the silica container (10; 10', 10'') to support the silica container (10; 10', 10'') during formation of a silicon melt (48) in the silica container (10; 10', 10'') and production of single crystal silicon (55) from the melt (48),
characterized in that the concentration of calcium present in the body is not in excess of about 1 ppm by weight.

10. A graphite support vessel according to claim 9, characterized in that the cumulative concentration of alkaline-earth metals and alkali metals present in the graphite body is not in excess of about 1 ppm by weight.
